# EUROPEAN PATENT APPLICATION

(11) **EP 4 550 408 A1**
(43) Date of publication of application: **07.05.2025**
(21) Application number: 23828664.5
(22) Date of filing: 25.05.2023
(51) Int. Cl.: H01L 23/473, H05K 7/20, H02M 7/04

(54) **UNIT**

(30) Priority: 28.06.2022 JP 2022103294
(71) Applicant: Jatco Ltd., Shizuoka 417-8585 (JP)
(72) Inventor: HAGIMORI, Hisaya, Fuji-shi, Shizuoka 417-8585 (JP); TANAKA, Daiki, Fuji-shi, Shizuoka 417-8585 (JP)
(74) Representative: Hoefer & Partner Patentanwälte mbB
(86) International application number: PCT/JP2023/019451
(87) International publication number: WO 2024/004456

(57) **Abstract**

[PROBLEM] To provide a structure in which a usage form of a fiber body based on a technical idea of performing cooling using an effect of turbulence is reflected.

[SOLUTION] A unit includes a cooling liquid, an electric circuit, and the fiber body. The electric circuit is disposed within a liquid flow path of the cooling liquid, and the electric circuit is supplied with a liquid flow passing through the fiber body.

## Description

### TECHNICAL FIELD

The present invention relates to a unit.

### BACKGROUND ART

Patent Document 1 discloses a cooling member in which a metal fiber sheet is accommodated in an accommodating body in contact with a heating element, and heat conducted from the heating element to the metal fiber sheet is taken by a refrigerant introduced into the accommodating body. Since the metal fiber sheet is made of copper fiber or aluminum fiber having high thermal conductivity, the metal fiber sheet is efficiently cooled by the refrigerant.

### PRIOR ART DOCUMENT

### PATENT DOCUMENT

Patent Document 1: JP2019-9433A

### SUMMARY OF INVENTION

### PROBLEMS TO BE SOLVED BY THE INVENTION

As a result of diligent studies, the present inventors have found that when a cooling liquid passes through fibers, turbulence occurs, and cooling is promoted by an effect of the turbulence. Furthermore, it has been found that when the cooling liquid passes through a surface of the fibers, turbulence is generated due to disorder of the surface of the fibers, and the cooling is promoted by an effect of the turbulence.

It means that, in some cases, cooling performance can be enhanced regardless of a material of a fiber body, and means that a fiber body can be used for cooling by a technical idea completely different from the technical idea described in Patent Document 1, that is, the technical idea of performing cooling by using the thermal conductivity of the metal fiber sheet. For this reason, it is desired to provide a unit having a new structure reflecting a usage form of a fiber body based on the technical idea of performing cooling using an effect of turbulence.

The present invention has been made in view of such a problem, and an object of the present invention is to provide a structure in which a usage form of a fiber body based on a technical idea of performing cooling using an effect of turbulence is reflected.

### SOLUTIONS TO THE PROBLEMS

A unit according to one aspect of the present invention includes a cooling liquid, an electric circuit, and a fiber body. The electric circuit is disposed within a liquid flow path of the cooling liquid, and the electric circuit is supplied with a liquid flow passing through the fiber body.

### ADVANTAGEOUS EFFECTS OF THE INVENTION

According to this aspect, a cooling efficiency of the electric circuit can be enhanced by an effect of turbulence of the liquid flow passing through the fiber body. Further, a contamination capturing function can be added to the fiber body by adopting a method of passing through the fiber body as a turbulence generating method.

### BRIEF DESCRIPTION OF DRAWINGS

[FIG. 1] FIG. 1 is a schematic configuration diagram of a unit according to the present embodiment.
[FIG. 2] FIG. 2 is a cross-sectional view showing a main part of an inverter.
[FIG. 3] FIG. 3 is a diagram showing an inverter according to a first modification.
[FIG. 4] FIG. 4 is a top view of a fiber body in a state of being disposed in the inverter.
[FIG. 5] FIG. 5 is a diagram showing an inverter according to a second modification.
[FIG. 6] FIG. 6 is a top view of a fiber body in a state of being disposed in the inverter.

### DESCRIPTION OF EMBODIMENTS

Hereinafter, an embodiment of the present invention will be described with reference to the accompanying drawings.

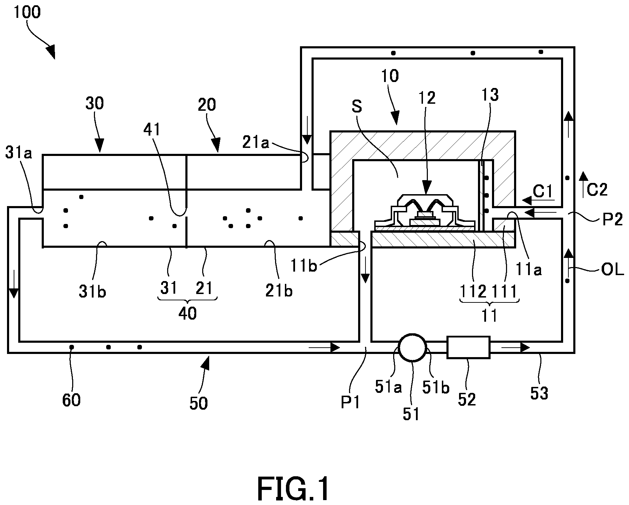

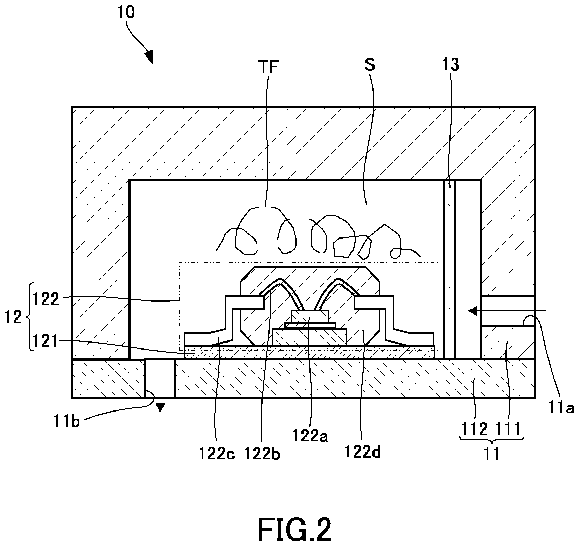

FIG. 1 is a schematic configuration diagram of a unit 100 according to the present embodiment. FIG. 2 is a cross-sectional view showing a main part of an inverter 10. In FIG. 1, regarding a rotary electric machine 20 and a speed reducer 30, a rotor and a stator of the rotary electric machine 20, a speed reduction gear mechanism of the speed reducer 30, and the like are not shown, and an oil reservoir 21b of the rotary electric machine 20 and an oil reservoir 31b of the speed reducer 30 are schematically shown in the cross-sectional view.

The unit 100 is mounted on, for example, an electric vehicle driven by the rotary electric machine 20. The unit 100 includes the inverter 10, the rotary electric machine 20, the speed reducer 30, and a cooling device 50. The inverter 10 includes a case 11, an electric circuit 12, and a fiber body 13. The case 11 is an inverter case and accommodates the electric circuit 12. An inside of the case 11 is an inside S of the inverter case, and is a space in which the electric circuit 12 is accommodated. The case 11 is made of, for example, an aluminum alloy. The case 11 may include a portion made of resin, for example. The case 11 includes a box-shaped portion 111 and a plate-shaped portion 112. The box-shaped portion 111 has a box shape with one surface opened, and the plate-shaped portion 112 closes the opening of the box-shaped portion 111. The case 11 is provided such that the plate-shaped portion 112 forms a lower surface in a gravity direction.

The case 11 includes an inlet 11a and an outlet 11b. The inlet 11a penetrates a side wall of the case 11 (a side wall of the box-shaped portion 111). The outlet 11b penetrates a bottom wall of the case 11 (the plate-shaped portion 112). An oil OL is introduced into the case 11 through the inlet 11a, and the oil OL in the case 11 is discharged from the outlet 11b. The outlet 11b is provided at a position where the electric circuit 12 is disposed in a flow (liquid flow) of the oil OL supplied from the inlet 11a into the case 11. A plurality of the outlets 11b may be provided. The oil OL corresponds to a cooling liquid.

The electric circuit 12 is provided in the case 11, that is, in the inside S of the inverter case. The electric circuit 12 includes a board 121 and a circuit part 122. In FIG. 2, the circuit part 122 is surrounded by a two-dot chain line. The board 121 is a printed circuit board and is disposed on the bottom wall of the case 11. The circuit part 122 is mounted on the board 121. The circuit part 122 is electrically connected to the board 121 by being connected to a circuit pattern of the board 121. The circuit part 122 is provided on a front-surface-direction-side of the board 121. The gravity direction corresponds to a front surface direction of the board 121, and the circuit part 122 is provided on the front-surface-direction-side of the board 121 by being provided on an upper side of the board 121 in the gravity direction. When the gravity direction corresponds to the front surface direction, the front-surface-direction-side may be a lower side in the gravity direction.

The circuit part 122 includes a semiconductor element 122a, a wire 122b, a lead frame 122c, and a mold resin 122d. The semiconductor element 122a is, for example, a power element, and is used as a switching element for an IGBT, a power MOSFET, or the like. A plurality of the semiconductor elements 122a can be provided, and for example, are arranged along a front-back direction of FIG. 2 (a direction orthogonal to a paper surface of FIG. 2). The semiconductor element 122a is electrically connected to the lead frame 122c via the wire 122b. The semiconductor element 122a is provided in the mold resin 122d and sealed by the mold resin 122d.

Heat dissipation from the semiconductor element 122a is performed via, for example, the mold resin 122d. On the other hand, the lead frame 122c protrudes from the mold resin 122d. Therefore, heat dissipation from the semiconductor element 122a can be promoted via the lead frame 122c. The lead frame 122c constitutes a heat dissipation promoting unit that promotes heat dissipation from the semiconductor element 122a to an outside of the mold resin 122d. In addition to the lead frame 122c, the circuit part 122 may further include a heat dissipation member that serves as a heat dissipation promoting unit to promote the heat dissipation from the semiconductor element 122a to the outside of the mold resin 122d.

The electric circuit 12 including the circuit part 122 is cooled by the oil OL supplied into the case 11. Since the oil OL has an insulation property, the oil OL does not particularly deteriorate an insulation state of the electric circuit 12.

By being provided in the case 11, the fiber body 13 is accommodated in the inside S of the inverter case together with the electric circuit 12. The fiber body 13 can be formed using, for example, a metal including an alloy or carbon as a material. Other materials may be used for the fiber body 13. The fiber body 13 has a plate shape. The fiber body 13 is disposed between the inlet 11a and the electric circuit 12 in a flow direction of the oil OL from the inlet 11a toward the outlet 11b.

The fiber body 13 divides the inside of the case 11 into a space communicating with the inlet 11a and a space provided with the electric circuit 12 and communicating with the outlet 11b. The fiber body 13 is disposed such that the spaces are arranged side by side in a lateral direction (left-right direction in FIG. 2). A horizontal direction orthogonal to the gravity direction corresponds to the lateral direction. A longitudinal direction corresponds to the gravity direction.

The inlet 11a overlaps the fiber body 13 as viewed in the front surface direction of the fiber body 13. The fiber body 13 overlaps the electric circuit 12 and an upper space of the electric circuit 12 in the case 11 as viewed in the front surface direction (a surplus space in the longitudinal direction in the case 11 as viewed from the electric circuit 12). The outlet 11b is offset from the electric circuit 12 as viewed in the front surface direction of the board 121.

Overlapping as viewed in a predetermined direction means overlapping in the predetermined direction, and means that a plurality of elements (components, portions, and the like) are arranged side by side in the predetermined direction. Therefore, when a plurality of elements are arranged side by side in a predetermined direction in the drawings, it may be assumed that the description contains a sentence explaining that the plurality of elements overlap each other as viewed in the predetermined direction. Offset as viewed in a predetermined direction means that a plurality of elements are not arranged side by side in the predetermined direction. Therefore, when a plurality of elements are not arranged side by side in a predetermined direction in the drawings, it may be assumed that the description contains a sentence explaining that the plurality of elements are offset from each other as viewed in the predetermined direction.

The rotary electric machine 20 is controlled by the inverter 10 to generate power. The power generated by the rotary electric machine 20 is transmitted to driving wheels of a vehicle via the speed reducer 30. The rotary electric machine 20 includes a case 21. The case 21 includes an inlet 21a and an oil reservoir 21b, and accommodates the rotor and the stator of the rotary electric machine 20. The case 21 is provided with the inverter 10 from the outside. The inverter 10 is provided on the case 21 from the lateral direction.

The inlet 21a penetrates an upper wall of the case 21, and allows communication between inside and outside of the case 21. The oil OL is introduced into the case 21 through the inlet 21a. The introduced oil OL falls by an action of gravity, and is stored in the oil reservoir 21b after lubricating the rotor and cooling the stator. A part of the stator can be disposed in the oil reservoir 21b, so that the oil OL stored in the oil reservoir 21b can be used for cooling the stator.

The speed reducer 30 decelerates an input rotation from the rotary electric machine 20 and outputs the decelerated rotation. The speed reducer 30 includes a case 31. The case 31 includes an outlet 31a and an oil reservoir 31b, and accommodates a speed reduction gear mechanism. The case 31 is integrated with the case 21 by, for example, bolt fastening, and constitutes a housing 40 of the rotary electric machine 20 and the speed reducer 30 together with the case 21.

The housing 40 includes a communication port 41, and the communication port 41 allows communication between the oil reservoir 21b in the case 21 and the oil reservoir 31b in the case 31. Therefore, the oil OL can be introduced from the oil reservoir 21b to the oil reservoir 31b through the communication port 41. The wall in which the communication port 41 is provided is constituted by, for example, a part of the case 21.

The oil reservoir 31b stores the oil OL introduced from the oil reservoir 21b. The oil OL stored in the oil reservoir 31b is scooped up by a rotating member such as a gear, and is used to lubricate the speed reduction gear mechanism. The oil OL is discharged from the oil reservoir 31b inside the case 31 through the outlet 31a. The speed reducer 30 corresponds to a power transmission mechanism.

The cooling device 50 includes an oil pump 51, an oil cooler 52, and a connection path 53. The oil pump 51 includes a suction port 51a and a discharge port 51b, and pumps the oil OL. The oil cooler 52 is connected to the discharge port 51b, and the oil cooler 52 cools the oil OL pumped by the oil pump 51. The oil pump 51 corresponds to a pump.

The connection path 53 is branched from the discharge port 51b of the oil pump 51 and connected to the inverter 10 and the rotary electric machine 20 via the oil cooler 52. The discharge port 51b is branched and connected to the inlet 11a and the inlet 21a through the connection path 53. The connection path 53 is further connected to the suction port 51a of the oil pump 51 after the outlet 11b of the inverter 10 and the outlet 31a of the speed reducer 30 merge together.

In this way, a first circulation path C1 and a second circulation path C2 are formed in the unit 100. The first circulation path C1 is a circulation path in which the oil OL passes from the oil pump 51 through the oil cooler 52 and the inverter 10 in this order and returns to the oil pump 51. The second circulation path C2 is a circulation path in which the oil OL passes from the oil pump 51 through the oil cooler 52, the rotary electric machine 20, and the speed reducer 30 in this order and returns to the oil pump 51. The first circulation path C1 corresponds to a liquid flow path.

In the first circulation path C1, the oil OL introduced into the case 11 through the inlet 11a passes through the fiber body 13 and is supplied to the electric circuit 12. Accordingly, in the unit 100, the inlet 11a for the oil OL is provided upstream of the fiber body 13. The oil OL supplied to the electric circuit 12 through the fiber body 13 is then discharged from the outlet 11b. Accordingly, in the unit 100, the outlet 11b for the oil OL is provided downstream of the fiber body 13.

When the oil OL passes through the fiber body 13, turbulence TF is generated, and the flow of the oil OL is disturbed around the electric circuit 12 including the upper space of the electric circuit 12. As a result, it is easier for the oil OL to take more heat from the electric circuit 12 than in a case where the turbulence TF is not generated, thereby promoting heat dissipation from the electric circuit 12 to the oil OL. That is, cooling of the electric circuit 12 is promoted by an effect of the turbulence of the oil OL passing through the fiber body 13. The electric circuit 12 including the circuit part 122 is disposed in the first circulation path C1, that is, in the flow (liquid flow) of the oil OL in the first circulation path C1, thereby directly being cooled by the oil OL. As a result, a better cooling effect can be obtained as compared with a case where the circuit part 122 is cooled via the board 121, for example.

In the second circulation path C2, the oil OL is introduced into the housing 40 through the inlet 21a and is discharged to the outside of the housing 40 through the outlet 31a. The discharged oil OL merges with the oil OL discharged from the outlet 11b at a merging point P1 of the first circulation path C1 and the second circulation path C2, and is then sucked into the oil pump 51.

That is, in the unit 100, downstream points of the rotary electric machine 20 and the speed reducer 30 and a downstream point of the electric circuit 12 merge at the merging point P1 and are sucked into the suction port 51a of the oil pump 51. The merging point P1 corresponds to these downstream points.

The oil OL sucked into the oil pump 51 is pumped again, and is distributed to the inverter 10 and the rotary electric machine 20 at a branch point P2 of the first circulation path C1 and the second circulation path C2. Accordingly, the oil OL supplied to the inverter 10 contains the oil OL flowing through the housing 40, that is, through the rotary electric machine 20 and the speed reducer 30.

On the other hand, in the rotary electric machine 20 and the speed reducer 30, metal-based contamination 60 such as metal pieces or metal powder is generated from a bearing or a gear, and the metal-based contamination 60 becomes a factor that deteriorates the insulation property of the oil OL. Therefore, although a strainer (filter) is present upstream of the oil pump 51, and the oil OL passing through the strainer can be introduced into the oil pump 51, if the oil OL containing the metal-based contamination 60 is supplied to the electric circuit 12 in the inverter 10, the insulation state of the electric circuit 12 may deteriorate.

In the present embodiment, the oil OL passing through the fiber body 13 is supplied to the electric circuit 12, and the contamination 60 contained in the oil OL is captured by the fiber body 13. Therefore, even when the oil OL is shared by the inverter 10, the rotary electric machine 20, and the speed reducer 30, it is possible to prevent the electric circuit 12 from being affected by deterioration of the insulation state of the electric circuit 12 due to the metal-based contamination 60 contained in the oil OL.

In the first circulation path C1, the oil OL flows from the oil pump 51 toward the fiber body 13, and the oil OL flows from the electric circuit 12 toward the oil pump 51. In this case, a suction force of the oil pump 51 acts upstream of the oil pump 51, that is, on the suction port 51a side of the oil pump 51.

Therefore, in the unit 100, backflow of the oil OL from the side opposite to the side where the fiber body 13 is provided toward the electric circuit 12 is prevented. As a result, the oil OL containing the contamination 60 is prevented from being supplied to the electric circuit 12 in a manner of flowing back through the first circulation path C1. In this case, it is also possible to select to not additionally provide a fiber body (a fiber body similar to the fiber body 13) serving as a filter on the downstream side of the electric circuit 12 in consideration of the backflow. As a result, the number of components may be reduced.

Next, main functions and effects of the present embodiment will be described.
(1) The unit 100 includes the oil OL, the electric circuit 12, and the fiber body 13. The electric circuit 12 is disposed in the first circulation path C1 of the oil OL. The oil OL that passes through the fiber body 13 is supplied to the electric circuit 12. According to such a configuration, the cooling efficiency of the electric circuit 12 can be increased by the effect of the turbulence of the oil OL passing through the fiber body 13. Further, a function of capturing the contamination 60 can be added to the fiber body 13 by adopting a method of passing through the fiber body 13 as a turbulence generating method.
(2) In the first circulation path C1, the oil OL flows from the oil pump 51 toward the fiber body 13, and the oil OL flows from the electric circuit 12 toward the oil pump 51. According to such a configuration, backflow of the oil OL from the side opposite to the side where the fiber body 13 is provided toward the electric circuit 12 can be prevented. Therefore, even if the contamination 60 is contained in the oil OL, the oil OL containing the contamination 60 is prevented from being supplied to the electric circuit 12 in a manner of flowing back through the first circulation path C1. In this case, it is also possible to select to not additionally provide a fiber body serving as a filter on the downstream side of the electric circuit 12 in consideration of the backflow. As a result, the number of components may be reduced.
(5) The unit 100 includes the rotary electric machine 20 and the speed reducer 30. The oil OL is used to lubricate the rotary electric machine 20 and the speed reducer 30. According to such a configuration, by sharing the oil OL, it is possible to simplify a cooling circuit structure including the cooling device 50 by, for example, sharing the oil pump 51 between the inverter 10, the rotary electric machine 20, and the speed reducer 30. Further, in this case, the technical significance is large in that it is possible to further suppress the influence from the metal-based contamination 60 generated in the rotary electric machine 20 or the speed reducer 30 on the electric circuit 12 by the fiber body 13.
(6) The unit 100 includes the rotary electric machine 20 and the speed reducer 30. The oil OL is used to lubricate the rotary electric machine 20 and the speed reducer 30. In the unit 100, the downstream points of the rotary electric machine 20 and the speed reducer 30 and the downstream point of the electric circuit 12 merge and then sucked into the suction port 51a of the oil pump 51. According to such a configuration, it is possible to prevent the oil OL containing the contamination 60 from directly flowing from the rotary electric machine 20 and the speed reducer 30 to the electric circuit 12 by the suction force of the oil pump 51.

### (First Modification)

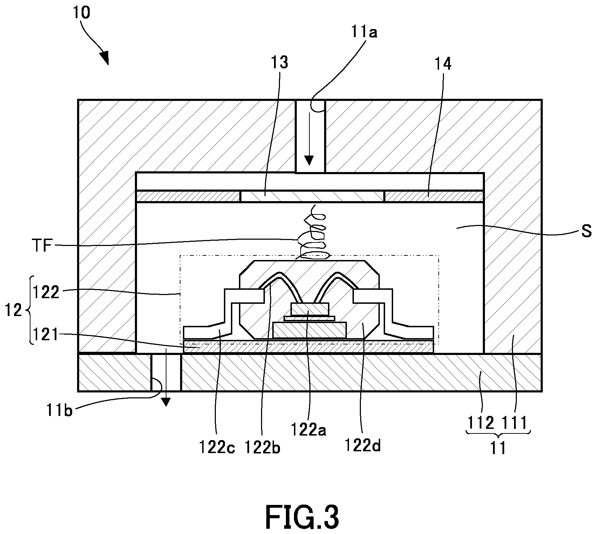

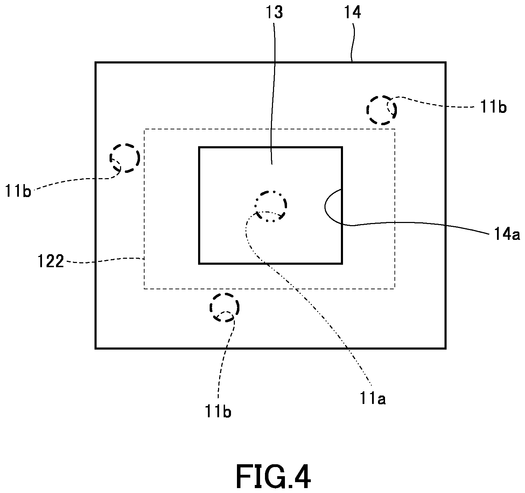

FIG. 3 is a diagram showing the inverter 10 according to a first modification. FIG. 4 is a top view of the fiber body 13 in a state of being disposed in the inverter 10. In FIG. 4, the disposition of the inlet 11a as viewed in the front surface direction of the board 121 is collectively shown by a two-dot chain line. In this modification, the inlet 11a penetrates an upper wall of the case 11, and accordingly, a bottom wall of the box-shaped portion 111 disposed on the upper side in the gravity direction.

In this modification, a plurality of (here, three) outlets 11b are provided. The plurality of outlets 11b are dispersedly provided around the electric circuit 12 as viewed in the front surface direction of the board 121. Each of the plurality of outlets 11b is offset from the circuit part 122 as viewed in the front surface direction of the board 121.

In this modification, the first circulation path C1 is a path having a plurality of partial branch paths branched from the plurality of outlets 11b. Each of the plurality of partial branch paths merges with the second circulation path C2 on the upstream side of the suction port 51a of the oil pump 51. For example, the plurality of partial branch paths may merge with each other and then merge with the second circulation path C2.

In this modification, a holding plate 14 that holds the fiber body 13 is further provided in the inverter 10. The holding plate 14 is a plate-shaped member that does not constitute any fiber body including the fiber body 13, and is made of, for example, metal or resin. The holding plate 14 includes a holding hole 14a at a center thereof, and the fiber body 13 is provided in the holding hole 14a. Therefore, the fiber body 13 is located at the center of the electric circuit 12 as viewed in the front surface direction of the board 121. A disposition range of the fiber body 13 is narrower than a disposition range of the circuit part 122 as viewed in the front surface direction of the board 121.

The fiber body 13 and the holding plate 14 divide the inside of the case 11 into a space communicating with the inlet 11a and a space provided with the electric circuit 12 and communicating with the outlet 11b. The fiber body 13 and the holding plate 14 are arranged such that the spaces are side by side in the longitudinal direction (upper-lower direction in FIG. 3).

The fiber body 13 provided in this manner is provided on the upper side of the electric circuit 12, and thus is disposed between the inlet 11a and the electric circuit 12 in the flow direction of the oil OL from the inlet 11a toward the outlet 11b. Therefore, the oil OL introduced from the inlet 11a into the case 11 passes through the fiber body 13, is supplied to the electric circuit 12, and is then discharged from the plurality of outlets 11b.

That is, in this modification, the electric circuit 12 is also disposed in the first circulation path C1. In this modification, in the first circulation path C1, the oil OL also flows from the oil pump 51 toward the fiber body 13, and the oil OL also flows from the electric circuit 12 toward the oil pump 51. The fiber body 13 is provided on the upper side in the gravity direction of the board 121, and thus is provided on the front-surface-direction-side of the board 121.

In this modification, the oil OL passing through the fiber body 13 also forms the turbulence TF and is supplied to the electric circuit 12. Accordingly, in this modification, the cooling of the electric circuit 12 is also promoted by the effect of the turbulence. In this modification, the inlet 11a, the fiber body 13, and the circuit part 122 overlap each other as viewed in the front surface direction of the board 121. Therefore, the cooling efficiency of the electric circuit 12 can also be increased by directly applying a part of the oil OL passing through the fiber body 13 to the circuit part 122. In this modification, the following functions and effects can also be obtained.

(3) The electric circuit 12 includes the board 121 and the circuit part 122 provided on the front-surface-direction-side of the board 121. The fiber body 13 is provided on the front-surface-direction-side of the board 121 with respect to the circuit part 122. According to such a configuration, a positional relation between the fiber body 13 and the circuit part 122 is a positional relation in which an area of a turbulence generation region can be increased as viewed from the front-surface-direction-side of the board 121. For this reason, it is possible to achieve cooling by the effect of the turbulence in a wider range with respect to the circuit part 122, and it is possible to further improve the cooling efficiency of the electric circuit 12.

(4) The unit 100 includes the inlet 11a for the oil OL on the upstream side of the fiber body 13, and includes the outlets 11b for the oil OL on the downstream side of the fiber body 13. As viewed in the front surface direction of the board 121, the inlet 11a overlaps the circuit part 122. As viewed in the front surface direction of the board 121, the outlets 11b are offset from the circuit part 122. According to such a configuration, it is possible to create a flow of the oil OL along the lateral direction (that is, a direction along a surface of the fiber body 13) from a portion overlapping the circuit part 122 toward an offset portion, that is, an outer region of the circuit part 122. As a result, the oil OL that takes heat from the circuit part 122 is efficiently discharged from the case 11, thereby improving the cooling efficiency of the electric circuit 12.

### (Second Modification)

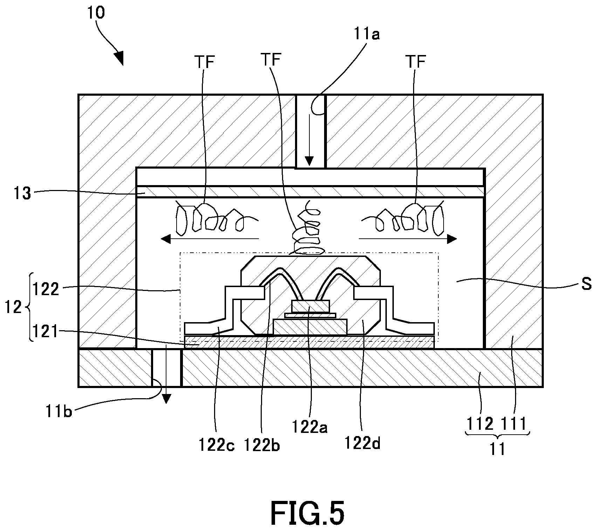

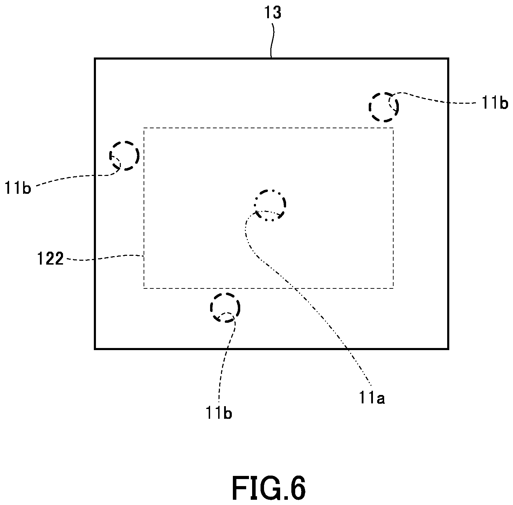

FIG. 5 is a diagram showing the inverter 10 according to a second modification. FIG. 6 is a top view of the fiber body 13 in a state of being disposed in the inverter 10. In FIG. 6, similarly to FIG. 5, the disposition of the inlet 11a is also collectively shown. The second modification is different from the first modification in that the holding plate 14 is not provided and the fiber body 13 is directly installed in the case 11. Therefore, in this modification, the fiber body 13 divides the inside of the case 11 into a space communicating with the inlet 11a and a space provided with the electric circuit 12 and communicating with the outlet 11b.

Accordingly, in this modification, the fiber body 13 overlaps the circuit part 122 as viewed in the front surface direction of the board 121, and the disposition range of the fiber body 13 is wider than the disposition range of the circuit part 122 as viewed in the front surface direction. As a result, in this modification, the flow of the oil OL along the lateral direction becomes a flow passing through the surface of the fiber body 13, and the turbulence TF is also generated in the lateral direction due to disorder of a fiber surface of the fiber body 13. The turbulence TF along the lateral direction further increases the area of the turbulence generation region as viewed from the front-surface-direction-side of the board 121, and increases an amount of the oil OL contributing to transport of the heat taken from the circuit part 122. Therefore, according to such a configuration, the cooling efficiency of the electric circuit 12 can be further improved as compared with the case of the first modification.

Although the embodiments of the present invention have been described above, the above embodiments merely exemplify some of application examples of the present invention and do not intend to limit the technical scope of the present invention to the specific configurations of the above embodiments.

For example, the cooling liquid may not necessarily be the oil OL, and a liquid having an insulation property other than the oil OL may be used as the cooling liquid. In order to suitably generate the turbulence TF, the fiber body 13 may be accommodated in the inside S of the inverter case, or the fiber body 13 may be provided in the inlet 11a, for example. The provision of the fiber body 13 in the inlet 11a includes attaching the fiber body 13 to the inlet 11a from the outside of the case 11, attaching the fiber body 13 to the inlet 11a from the inside of the case 11 (the inside S of the inverter case), and providing the fiber body 13 in the middle of the inlet 11a.

The unit 100 may include the rotary electric machine 20 and/or the speed reducer 30, that is, include at least one of the rotary electric machine 20 and the speed reducer 30. In this case, the unit 100 can also be referred to as, for example, a motor unit (a unit including at least a motor) or a power transmission device (a device including at least a power transmission mechanism). The motor is a rotary electric machine having an electric motor function and/or a generator function (at least one of the electric motor function and the generator function). The power transmission mechanism is, for example, a gear mechanism and/or a differential gear mechanism. A device (unit) including a motor and a power transmission mechanism is included in concepts of both the motor unit and the power transmission device.

### DESCRIPTION OF REFERENCE SIGNS

- 10: inverter

- 11: case
- 11a: inlet
- 11b: outlet
- 12: electric circuit
- 121: board
- 122: circuit part
- 13: fiber body
- 20: rotary electric machine
- 30: speed reducer (power transmission mechanism)
- 50: cooling device
- 51: oil pump (pump)
- 60: contamination
- 100: unit
- C1: first circulation path (liquid flow path)
- OL: oil (cooling liquid)
- P1: merging point (downstream point)
- TF: turbulence

## Claims

1. A unit, comprising:
a cooling liquid;
an electric circuit; and
a fiber body, wherein
the electric circuit is disposed within a liquid flow path of the cooling liquid, and
the electric circuit is supplied with a liquid flow passing through the fiber body.

2. The unit according to claim 1, wherein
in the liquid flow path, a liquid flow flows from a pump toward the fiber body, and a liquid flow flows from the electric circuit toward the pump.

3. The unit according to claim 1, wherein
the electric circuit includes a board and a circuit part provided on a front-surface-direction-side of the board, and
the fiber body is provided on the front-surface-direction-side with respect to the circuit part.

4. The unit according to claim 3, further comprising:
an inlet for the liquid flow provided upstream of the fiber body; and
an outlet for the liquid flow provided downstream of the fiber body, wherein
the inlet overlaps the circuit part as viewed in a front surface direction of the board, and
the outlet is offset from the circuit part as viewed in the front surface direction.

5. The unit according to any one of claims 1 to 4, further comprising:
a rotary electric machine and/or a power transmission mechanism, wherein
the cooling liquid is used to lubricate the rotary electric machine and/or the power transmission mechanism.

6. The unit according to claim 1, further comprising:
a rotary electric machine and/or a power transmission mechanism, wherein
the cooling liquid is used to lubricate the rotary electric machine and/or the power transmission mechanism, and
a downstream point of the rotary electric machine and/or the power transmission mechanism and a downstream point of the electric circuit merge and the cooling liquid is drawn into a suction port of a pump.
